# EUROPEAN PATENT SPECIFICATION

(11) **EP 3 104 999 B1**
(45) Date of publication and mention of the grant of the patent: **22.01.2025**
(21) Application number: 15704854.7
(22) Date of filing: 03.02.2015
(51) Int. Cl.: B23K 1/005, B23K 26/00, B23K 26/08, B21F 15/10, B23K 20/00, H01L 23/00

(54) **LASER SOLDERING SYSTEM**
LASERLÖTSYSTEM
SYSTÈME DE SOUDAGE LASER

(30) Priority: 13.02.2014 CN 201410051135
(43) Date of publication of application: 21.12.2016
(73) Proprietor: Tyco Electronics (Shanghai) Co. Ltd., Shanghai 200233 (CN); TE Connectivity Solutions GmbH, 8200 Schaffhausen (CH); Tyco Electronics (Dongguan) Ltd., Dongguan, Guangdong 523958 (CN)
(72) Inventor: SHEN, Hongzhou, Dongguan Guangdong 523958 (CN); ZHANG, Dandan, Shanghai 200233 (CN); LU, Roberto Francisco-yi, Bellevue 98006 (US); DUBNICZKI, George J., Shanghai 200233 (CN); ZENG, Qinglong, Shenzhen Guangdong (CN)
(74) Representative: Grünecker Patent- und Rechtsanwälte PartG mbB
(86) International application number: PCT/IB2015/050813
(87) International publication number: WO 2015/121774

(56) References cited:
- CA-A1- 2 031 392
- JP-A- H08 148 256
- JP-B2- 3 028 740
- US-A- 5 021 630

## Description

### BACKGROUND OF THE INVENTION

### Field of the Invention

The present invention relates to a soldering system for automatically soldering a product, more particularly, relates to a laser soldering system for automatically soldering a circuit board.

### Description of the Related Art

In prior art, soldering a complicated product in high precision is a very difficult task. At present, in order to solder wires onto hundreds of tiny pins or pads on a circuit board, a soldering worker has to use magnifying glass. However, even under the assistance of the magnifying glass, the soldering worker still takes a lot of time, sometimes several days, to solder a complicated circuit board product. Furthermore, the soldering worker cannot perform the soldering in high precision.

In a laser soldering system in the prior art, the wire is generally gripped and held directly by a finger-typed gripper. However, during soldering, the finger-typed gripper only can grip and hold both sides of the wire, and cannot press the wire downward directly from the top of the wire with respect to the circuit board. Thereby, the wire cannot be tightly and reliably pressed on a pad on the circuit board, it may cause a pseudo solder joint, decreasing the soldering quality of the product.

Laser soldering systems of the art are, for instance, disclosed in CA 2 031 392 A1 or US 5,021,630 A.

### SUMMARY OF THE INVENTION

The present invention has been made to overcome or alleviate at least one aspect of the above mentioned disadvantages.

According to an object of the present invention, there is provided a laser soldering system capable of effectively preventing a pseudo solder joint from occurring on a product.

According to an exemplary embodiment of the present invention, the object is a wire, the product to be soldered is a circuit board, and the target location is a pad on the circuit board.

According to another exemplary embodiment of the present invention, the gripper is configured to position the wire, so that a center line of the wire is aligned with a center line of the respective pad.

According to another exemplary embodiment not forming part of the present invention, the transparent member protrudes from the presser, and has an arc recess surface matched with and directly pressed on a top surface of the wire.

According to another exemplary embodiment not forming part of the present invention, the transparent member is provided in a slot formed in the presser, the wire is positioned between opposite sidewalls of the slot, and the transparent member directly presses on the top of the wire against the circuit board.

According to another exemplary embodiment not forming part of the present invention, the sidewalls of the slot are made of thermal insulation material, so as to prevent heat from being transferred from one pad being currently soldered to another pad adjacent to the one pad.

According to another exemplary embodiment of the present invention, the laser soldering system is configured to pre-arrange the wires on the respective pads of the circuit board before accurately positioning the wires by the gripper.

According to another exemplary embodiment of the present invention, the laser soldering system is configured to apply a welding wire to the product during soldering.

According to another exemplary embodiment of the present invention, the moving system is a multi-freedom robot.

According to another exemplary embodiment of the present invention, the gripper and the presser both are removably mounted on an installation plate, and the installation plate is fixed on an end arm of the robot.

According to another exemplary embodiment of the present invention, the transparent member is an elastic member.

According to another exemplary embodiment of the present invention, the laser soldering system automatically performs a soldering work under the control of a program.

According to another aspect of the present invention, there is provided a laser soldering system, comprising: a vision system; a moving system; a laser source configured for heating a soldering flux to solder an object onto a target location on a product to be soldered; and a gripper mounted on the moving system and capable of gripping the object and placing the object accurately on the target location under the guidance of the vision system, wherein the gripper is provided with a transparent member configured to directly press on the top of the accurately positioned object against the product, so as to hold the position of the object during soldering the object onto the product, and wherein a laser beam from the laser source transmits through the transparent member and heats the soldering flux.

In the laser soldering system according to the above various embodiments of the present invention, the transparent member directly presses on the top of the wire against the pad. Thereby, the wire can be tightly and reliably pressed on the pad and tightly contact the pad during soldering. Thereby, it can effectively prevent a pseudo solder joint from being occurred on the product, improving the soldering quality.

Furthermore, in some embodiments, the laser soldering system automatically performs a soldering work under the control of a program, greatly increasing the efficiency and the precision to solder the complicated product.

### BRIEF DESCRIPTION OF THE DRAWINGS

The above and other features of the present invention will become more apparent by describing in detail exemplary embodiments thereof with reference to the accompanying drawings, in which:
Fig.1 is an illustratively perspective view of a laser soldering system according to a first exemplary embodiment of the present invention;
Fig.2 is an illustratively local enlarged view of the laser soldering system of Fig.1;
Fig.3 is an illustratively enlarged view of a presser of the laser soldering system of Fig.1;
Fig.4 is an illustratively enlarged view of a gripper of the laser soldering system of Fig.1;
Fig.5 is an illustratively enlarged view of a presser of a laser soldering system according to a second exemplary embodiment of the present invention; and
Fig.6 is an illustratively enlarged view of a gripper of a laser soldering system according to a third exemplary embodiment of the present invention.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to an embodiment not forming part of the present invention, there is provided a laser soldering system, comprising: a vision system; a moving system; a laser source configured to heat a soldering flux to solder an object onto a target location on a product to be soldered; a gripper mounted on the moving system and constructed to grip the object and place the object accurately on the target location under the guidance of the vision system; and a presser mounted on the moving system and constructed to press the accurately positioned object against the product to hold the position of the object during soldering the object onto the product. The presser has a transparent member for directly pressing on the top of the object. A laser beam from the laser source transmits through the transparent member to heat the soldering flux.

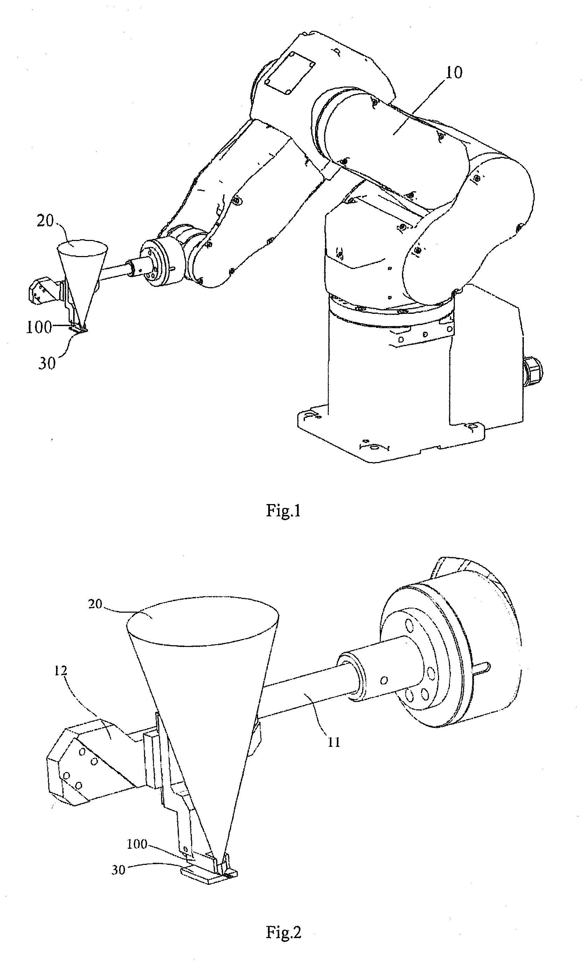

Figs.1-4 show a laser soldering system according to a first exemplary embodiment of the present invention.

As shown in Figs.1-4, the laser soldering system mainly comprises a vision system (not shown), a moving system 10, a laser source 20, a gripper 200 and a presser 100.

In an embodiment, the vision system may comprise at least one camera. The laser source 20 is configured to heat a soldering flux to solder an object 1 onto a target location 2 on a product 30 to be soldered.

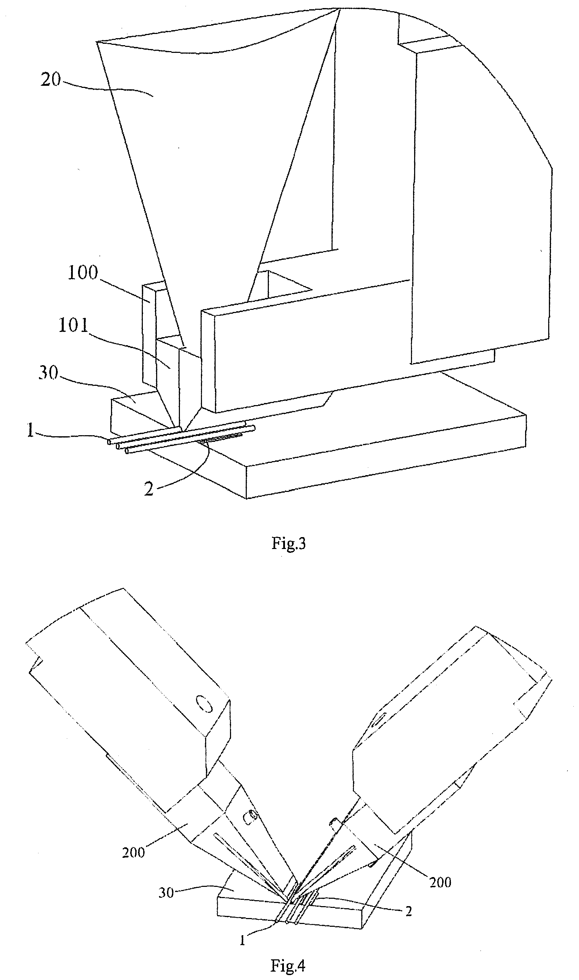

As shown in Fig.4, the gripper 200 is mounted on the moving system 10 and constructed to grip the object 1 and place the object 1 accurately on the target location 2 under the guidance of the vision system.

The presser 100 is mounted on the moving system 10 and constructed to press the accurately positioned object 1 to hold the position of the object 1 during soldering the object 1 onto the product 30.

As shown in Fig.3, the presser 100 has a transparent member 101 for directly pressing on the top of the object 1 with respect to the product 30. A laser beam emitted from the laser source 20 transmits through the transparent member 101 to heat the soldering flux, so as to solder the object 1 onto the respective target location 2 on the product 30 to be soldered.

In an exemplary embodiment of the present invention, as shown in Figs.1-4, the object 1 is a wire, the product 30 to be soldered is a circuit board, and the target location 2 is a pad on the circuit board.

In the illustrated embodiment, the gripper 200 is configured to grip the object 1 and place the object 1 accurately on the target location 2 under the guidance of the vision system, so that a center line of the wire 1 is aligned with a center line of the respective pad 2.

As shown in Fig.3, the transparent member 101 protrudes from the presser 100, and has an arc recess surface matched with and directly pressed on a top surface of the wire 1 against the pad 2.

In an exemplary embodiment of the present invention, the transparent member 101 may be formed as an elastic member. In this way, it can protect the wire 1 from damage. Furthermore, the elastic transparent member 101 may more reliably hold the wire 1 on the pad 2.

In an exemplary embodiment of the present invention, before accurately positioning the wires 1 by the gripper 200, a plurality of wires 1 to be soldered are pre-arranged on the respective pads 2 of the circuit board 30, for example, by manual or machine.

In an exemplary embodiment of the present invention, the soldering flux may be a conductive paste pre-printed on the product 30, an alloy solder pre-melt or fused on the product 30, or a welding wire applied to product 30 during soldering.

In an exemplary embodiment of the present invention, the moving system 10 may be a multi-freedom robot, for example, a 6-freedom robot.

As shown in Figs.2 and 4, the gripper 200 and the presser 100 both are removably mounted on an installation plate 12, and the installation plate 12 is fixed on an end arm 11 of the robot 10.

In an embodiment of the present invention, the laser soldering system automatically performs a soldering work on a complicated product under the control of a program pre-stored in the moving system 10. Compared with soldering the complicated product by manual, it greatly increases the efficiency and the precision for soldering the complicated product.

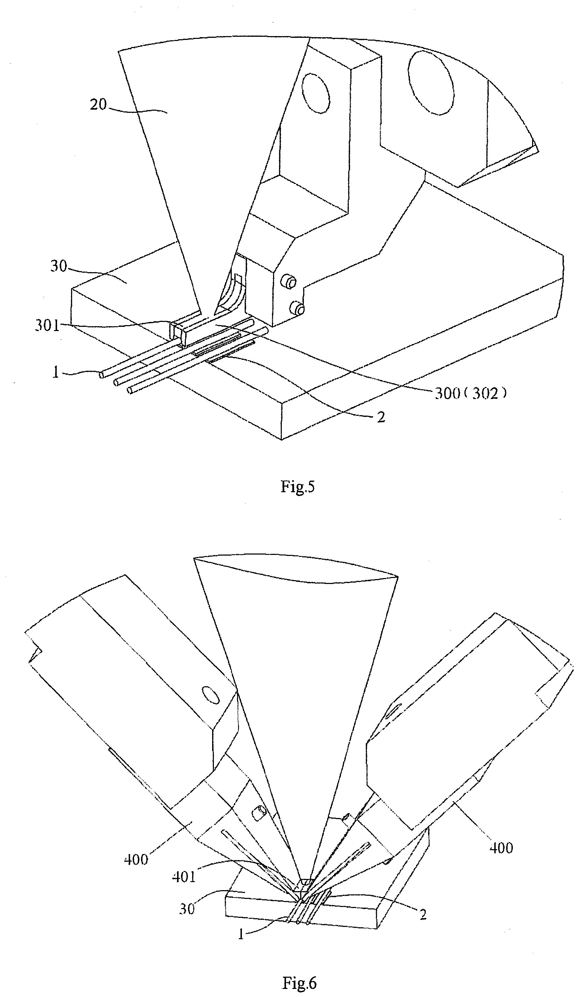

Fig.5 is an illustratively enlarged view of a presser of a laser soldering system according to a second exemplary embodiment of the present invention.

The laser soldering system shown in Fig.5 is different from the laser soldering system shown in Fig.1 only in the configuration of the presser. Thereby, hereafter it will only describe the presser of the laser soldering system according to the second embodiment shown in Fig.5.

As shown in Fig.5, the transparent member 301 is provided in a slot formed in the presser 300. The wire 1 is positioned between opposite sidewalls 302 of the slot, and the transparent member 301 directly presses on the top of the wire 1 against the product 30, for example, a circuit board.

In an exemplary embodiment of the present invention, the sidewalls 302 of the slot are made of thermal insulation material, so as to prevent heat from being transferred from one pad being currently soldered to another pad adjacent to the one pad. In this way, it can protect the soldering flux on the another pad, adjacent to the currently soldered pad, from being disadvantageously affected by the heat generated during soldering the current pad.

Fig.6 is an illustratively enlarged view of a gripper of a laser soldering system according to a third exemplary embodiment of the present invention.

In the laser soldering system according to the third embodiment shown in Fig.6, the presser 100 specially for pressing the wire in the laser soldering system according to the first embodiment shown in Fig.1 is omitted.

As shown in Fig.6, the gripper 400 is integrated with a transparent member 401, instead of individually providing a special presser. After the gripper 400 is constructed to grip the object 1 and place the object 1 accurately on the target location 2 under the guidance of the vision system, the transparent member 401 is constructed to directly press on the top of the accurately positioned object 1 with respect to the product 30, for example, a circuit board, so as to hold the position of the object 1 during soldering the object 1 onto the product 30. A laser beam from the laser source 20 transmits through the transparent member 401 and heats the soldering flux.

In the third embodiment shown in Fig.6, since the transparent member 401 is integrated on the gripper 400, the presser specially for pressing the wire is omitted, simplifying the structure of the laser soldering system.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the scope of the invention which is defined in the appended claims.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A laser soldering system, comprising:
a vision system;
a moving system (10);
a laser source (20) for heating a soldering flux to solder an object (1) onto a target location (2) on a product (30) to be soldered; and
a gripper (400) mounted on the moving system (10) and configured to grip the object (1) and place the object (1) accurately on the target location (2) under the guidance of the vision system,
wherein the gripper (400) is provided with a transparent member (401) configured to directly press on the top of the accurately positioned object (1) against the product, so as to hold the position of the object (1) during soldering the object (1) onto the product (30), and
wherein a laser beam from the laser source (20) transmits through the transparent member (401) and heats the soldering flux.

2. The laser soldering system according to claim 1,
wherein the object (1) is a wire, the product (30) to be soldered is a circuit board, and the target location (2) is a pad on the circuit board.

3. The laser soldering system according to claim 2,
wherein the gripper (400) is configured to grip the wire (1) and position the wire (1) accurately on the target location under the guidance of the vision system, so that a center line of the wire (1) is aligned with a center line of the respective pad (2).

4. The laser soldering system according to claim 1,
wherein the soldering flux is a welding wire applied to the product (30) during soldering.

5. The laser soldering system according to claim 1, wherein the moving system (10) is a multi-freedom robot.

6. The laser soldering system according to claim 1,
wherein the gripper (400) is removably mounted on an installation plate (12), and the installation plate (12) is fixed on an end arm (11) of the robot (10).

7. The laser soldering system according to claim 1, wherein the transparent member (401) is an elastic member.

## Patentansprüche

1. Ein Laserlötsystem, umfassend:
ein Sichtsystem;
ein Bewegungssystem (10);
eine Laserquelle (20) zum Erhitzen eines Lötflussmittels, um ein Objekt (1) auf eine Zielstelle (2) auf einem zu lötenden Produkt (30) zu löten; und
einen Greifer (400), der an dem Bewegungssystem (10) angebracht und so konfiguriert ist, dass er das Objekt (1) greift und das Objekt (1) unter der Führung des Sichtsystems genau an der Zielposition (2) platziert,
wobei der Greifer (400) mit einem transparenten Element (401) versehen ist, das so konfiguriert ist, dass es direkt auf die Oberseite des genau positionierten Objekts (1) gegen das Produkt drückt, um die Position des Objekts (1) während des Lötens des Objekts (1) auf das Produkt (30) zu halten, und
wobei ein Laserstrahl von der Laserquelle (20) durch das transparente Element (401) hindurchgeht und das Lötflussmittel erhitzt.

2. Das Laserlötsystem gemäß Anspruch 1,
wobei das Objekt (1) ein Draht ist, das zu lötende Produkt (30) eine Leiterplatte ist und die Zielposition (2) ein Pad auf der Leiterplatte ist.

3. Das Laserlötsystem gemäß Anspruch 2,
wobei der Greifer (400) so konfiguriert ist, dass er den Draht (1) greift und den Draht (1) unter der Führung des Sichtsystems genau an der Zielposition positioniert, so dass eine Mittellinie des Drahtes (1) mit einer Mittellinie des jeweiligen Pads (2) ausgerichtet ist.

4. Das Laserlötsystem gemäß Anspruch 1,
wobei das Lötflussmittel ein Schweißdraht ist, der während des Lötens auf das Produkt (30) aufgebracht wird.

5. Das Laserlötsystem nach Anspruch 1, wobei das Bewegungssystem (10) ein Roboter mit mehreren Freiheitsgraden ist.

6. Das Laserlötsystem nach Anspruch 1,
wobei der Greifer (400) abnehmbar an einer Installationsplatte (12) angebracht ist und die Installationsplatte (12) an einem Endarm (11) des Roboters (10) befestigt ist.

7. Das Laserlötsystem gemäß Anspruch 1, wobei das transparente Element (401) ein elastisches Element ist.

## Revendications

1. Système de soudage laser, comprenant :
un système de vision ;
un système mobile (10) ;
une source laser (20) pour chauffer un flux de soudage afin de souder un objet (1) sur un emplacement cible (2) sur un produit (30) à souder ; et
un dispositif de préhension (400) monté sur le système mobile (10) et configuré pour saisir l'objet (1) et placer avec précision l'objet (1) sur l'emplacement cible (2) sous le guidage du système de vision,
dans lequel le dispositif de préhension (400) est pourvu d'un élément transparent (401) configuré pour appuyer directement sur le dessus de l'objet (1) positionné avec précision contre le produit, de manière à maintenir la position de l'objet (1) pendant le soudage de l'objet (1) sur le produit (30), et
dans lequel un faisceau laser provenant de la source laser (20) est transmis à travers l'élément transparent (401) et chauffe le flux de soudage.

2. Système de soudage laser selon la revendication 1,
dans lequel l'objet (1) est un fil, le produit (30) à souder est une carte de circuit imprimé, et l'emplacement cible (2) est un plot sur la carte de circuit imprimé.

3. Système de soudage laser selon la revendication 2,
dans lequel le dispositif de préhension (400) est configuré pour saisir le fil (1) et positionner le fil (1) avec précision sur l'emplacement cible sous le guidage du système de vision, de sorte qu'une ligne centrale du fil (1) est alignée avec une ligne centrale du plot (2) respectif.

4. Système de soudage laser selon la revendication 1,
dans lequel le flux de soudage est un fil de soudure appliqué au produit (30) pendant le soudage.

5. Système de soudage laser selon la revendication 1, dans lequel le système mobile (10) est un robot à degrés de liberté multiples.

6. Système de soudage laser selon la revendication 1,
dans lequel le dispositif de préhension (400) est monté de manière amovible sur une plaque d'installation (12), et la plaque d'installation (12) est fixée sur un bras d'extrémité (11) du robot (10).

7. Système de soudage laser selon la revendication 1, dans lequel l'élément transparent (401) est un élément élastique.
